# EUROPEAN PATENT APPLICATION

(11) **EP 1 617 476 A2**
(43) Date of publication of application: **18.01.2006**
(21) Application number: 05254446.7
(22) Date of filing: 15.07.2005
(51) Int. Cl.: H01L 27/06, H01L 27/092, H01L 21/761, H01L 21/762

(54) **Vertical integration in power integrated circuits**

(30) Priority: 16.07.2004 GB 0415885; 20.07.2004 GB 0416176
(71) Applicant: Power Electronics Design Centre, Singleton Park Swansea SA2 8PP (GB)
(72) Inventor: Mawby, Philip, Swansea SA2 8PP (GB); Igic, Petar, Swansea SA2 8PP (GB); Holland, Paul, Swansea SA2 8PP (GB); Batcup, Steve, Swansea SA2 8PP (GB); Frank, James, Swansea SA2 8PP (GB); Wissan, Jamal, Swansea SA2 8PP (GB); Leach, Peter, Swansea SA2 8PP (GB); Starke, Thomas, Swansea SA2 8PP (GB); Hussein, Shahzad, Swansea SA2 8PP (GB)
(74) Representative: Gallafent, Antony Xavier

(57) **Abstract**

The present invention relates to a device and method of producing such a device to electrically isolate two device regions of a semi-conductor substrate for use in an integrated circuit. The method comprises providing a trench for extending from a rear or bottom surface of a wafer 1 to an impurity region 3, thereby achieving complete isolation between two device regions 10 of the wafer.

## Description

This invention relates generally to power integrated circuit devices and technology and, more particularly, to a method of achieving vertical insulation in power integrated circuit technology, such as multiple monolithic integration of vertical power devices with low voltage (logic) circuitry in a semiconductor wafer such that the power devices are completely electrically isolated from each other and from the logic circuitry by a combination of dielectric and junction isolation.

Within the last decade, power integrated circuits (PICs) have gained huge interest in system integrations. In PICs, high voltage poser devices are integrated on a common semiconductor substrate (usually silicon), used for low voltage circuits. Lateral devices have generally been used for this type of application as they are easily integrated into existing processes and they have all of their terminals available at the surface. Lateral double diffused power MOSFETs (LDMOSFETs) or lateral IGBTs are typically used.

In the case of monolithic integration of high voltage power devices on a common semiconductor substrate with low voltage logic circuitry, it is obviously necessary to isolate such power devices from each other and from the low voltage circuitry. In this regard, the earliest type of isolation was known as junction isolation. This type of isolation is based on a basic physical property of the silicon p-n diode: if a reverse bias voltage is applied to the junction, no current will be conducted. A reverse bias voltage means that the p-type side (the anode) is at a lower voltage potential than the n-type side (the cathode). However, a practical p-n junction suffers from several non-ideal properties, including leakage current and its inherent capacitance.

Conventional extended drain LDMOSFETs are used for applications requiring voltages up to around 100V. However, the introduction of the Reduced Surface Field devices (RESURF LDMOSFET) in the early eighties allowed voltages to be significantly increased up to 700V). Such devices are majority carrier devices, which means that all the current is carried by one carrier type, and these devices can therefore switch very quickly. For lower on-state resistances, it is possible to replace the LDMOS transistor with a lateral IGBT (LIGBT), which will have a lower on-state resistance, but as it is a bipolar device will have a much slower switching speed. Junction Isolation (JI) is usually used to separate such devices from each other and from the low-voltage circuitry. Alternatively, SOI (silicon oxide) technologies, such as SOI-SIMOX, SOI-Wafer Bonding or SOI-Unibond, can be employed to adequately protect low voltage devices from carrier injection. Consequently, SOI devices have very low interference between adjacent devices, high speed and low area consumption, but they are more expensive and they display self-heating problems (thermal conductivity of silicon oxide being significantly larger than that of silicon).

Other technologies allow the integration of a single VDMOS transistor with low-voltage control functionality. Here the DMOS is a vertical device with a drain contact on the backside of the wafer. This technology is extensively used at higher voltages, but at lower voltages or where several devices are needed, alternatives such as the JI-LDMOS solution are sought.

Thus, junction isolation is not ideal, since under certain transient conditions, high injection conditions may well occur. Under such conditions, high levels of minority carriers will be injected into the substrate and will lead to interference with the low-voltage circuitry. In order to tackle this problem, SOI (Silicon on Insulator) technologies have been developed to provide the requisite dielectric isolation. SOI technology enables the starting substrate to be created with the insulating material already present. For high-voltage technologies, a specific type known as "thick" or "bonded" SOI is used. These terms refer to the manufacturing process that involves growing a thick layer of SiO₂ on one handle wafer and then bonding another wafer on top of that grown oxide. The top wafer is then put through a grind and polish process to achieve semiconductor grade starting material. The result is that the top of the wafer (where the devices are formed) is electrically insulated from the bottom wafer (which is attached to the conducting lead-frame in the package). Known types of SOI isolation techniques include SOI-SIMOX, SOI-Wafer Bonding and SOI-Unibond, and these technologies can be adequately used in many cases to protect low voltage devices from carrier injection. SOI devices have very low interference between adjacent devices, as well as facilitating high speed operation and requiring relatively small area consumption. On the other hand, however, these technologies are relatively very expensive and display self-heating problems (thermal conductivity of silicon dioxide being significantly larger than that of silicon).

Advances in silicon etching technology in recent years (i.e. the ability to control precise removal of specific areas of silicon) has enabled the ability to physically slice components apart on the silicon wafer by creating narrow trenches. Separated physically, the components or devices achieve close to ideal electrical isolation. For practical manufacturing and ultimate mechanical stability reasons, such trenches tend not to be left empty and they are typically lines with an insulating material, such as silicon dioxide, and then filled with another material or mechanical filler, such as another insulating material, glass, metal or a non-crystalline or "poly" silicon. This type of isolation is known as trench isolation. In a general sense, trench isolation is a type of dielectric isolation, defined as the use of non-conducting material to isolate components, such that almost all of the non-idealities of junction isolation are eliminated.

In spite of big improvements having been made in the last decade in relation to lateral power devices, their performances (current and voltage handling capabilities) are still far behind those of vertical power devices. Vertical power devices have bottom contacts (drain-VDMOSFET, anode-IGBT), thus making integration of more than one device impossible using existing isolation techniques.

It is an object of the present invention to provide an acceptably inexpensive process that allows integration of a plurality of power devices together with the required low voltage (logic) circuitry, the power devices being electrically isolated from one another and from the low voltage circuitry. It is also an object of the invention to provide an integrated circuit manufactured using such a process.

In accordance with a first aspect of the present invention, there is provided a method of electrically isolating two device regions of a semiconductor substrate for use in an integrated circuit, the method comprising providing an impurity region within said semiconductor substrate for providing a diode junction between said two device regions, and creating a trench between said two device regions, said trench extending from a surface of said semiconductor substrate to said impurity region.

Also in accordance with a first aspect of the present invention, there is provided a method of manufacturing an integrated circuit comprising a first, high voltage power device, and a second device, the method comprising providing a semiconductor substrate of a first type, forming an impurity region of a second type in said semiconductor substrate for defining a diode junction between two device regions thereof, creating a trench between said two device regions, said trench extending from a surface of said semiconductor substrate to said impurity region, and forming a high voltage power device in one of said device regions and a second device in the other of said device regions.

The present invention extends still further to an integrated circuit comprising a first, high voltage, power device and a second device integrated on a common semiconductor substrate of a first type, the integrated circuit further comprising an impurity region of a second type in said semiconductor substrate for defining a diode junction between said first and second devices, and a trench extending from a surface of said semiconductor substrate to said impurity region.

Thus, the present invention provides means for vertical isolation in power integrated circuits which combines dielectric and junction isolation, and as a result of which two or more device regions of a semiconductor wafer/chip are completely electrically isolated from each other under the correct biasing conditions (i.e. a reverse bias voltage being applied across the diode junction provided by the impurity region).

In a first exemplary process according to the invention, the impurity region is first implanted or deposited within the semiconductor substrate, following which the trench is created which extends from a surface of the semiconductor substrate to the impurity region. Preferably, the impurity region is subjected to an annealing process prior to creation of the trench.

In a second exemplary process according to the invention, a trench is first formed in a surface of the semiconductor substrate which defines two device regions on either side thereof, following which at least one and, more preferably, at least two impurity regions are formed within the semiconductor substrate. Beneficially, a first impurity region is formed adjacent the trough of the trench and a second impurity region is formed adjacent the surface of the semiconductor substrate opposing the surface in which the trench is formed. Preferably, an annealing process is performed to cause the impurity regions to grow and, as a result, join together to substantially fill a portion of the semiconductor substrate between the two device regions defined by the trench.

In a third exemplary process according to the invention, a buried layer of the second type is formed adjacent a first surface of the semiconductor substrate, following which an epitaxial layer, preferably of the first type, is formed on said first surface of the semiconductor substrate. An impurity region of the second type is then preferably formed within the epitaxial layer, and an annealing process beneficially performed so as to cause the buried layer and the impurity region to grow and join together to form a diode junction between two device regions of the substrate. A trench may then be formed which extends from the surface of the substrate opposing said first surface to the buried layer.

The trench may be formed by means of, for example, wet chemical etching or plasma ion etching.

The impurity region may be formed by means of implantation or deposition.

The semiconductor substrate may be of n-type semiconductor material, in which case the impurity region is preferably of p-type. Alternatively, the semiconductor substrate may be of p-type material, in which case the impurity region is preferably of n-type.

The semiconductor substrate is beneficially a silicon substrate. The second device may comprise a second, high voltage power device, or it may comprise low voltage circuitry.

In accordance with a second aspect of the present invention, there is provided a method of isolating a high voltage power device from a second device, said high voltage power device and said second device being provided on a semiconductor wafer comprising first and second opposing surfaces, the method comprising forming a first isolation region in said first surface of said semiconductor wafer, said first isolation region comprising an insulating material separating said high voltage power device and said second device, said insulating material extending between first and second opposing edges of said semiconductor wafer and having therein one or more air gaps, the method further comprising forming a second isolation region in said second surface of said semiconductor wafer between said high voltage power device and said second device, said second isolation region comprising a trench extending from said second surface to said first isolation region.

Also in accordance with the second aspect of the present invention, there is provided a method of fabricating an integrated circuit, the method comprising providing a semiconductor wafer having first and second opposing surfaces, forming a first isolation region in said first surface of said semiconductor wafer, said first isolation region comprising an insulating material separating first and second device regions of said semiconductor wafer, said insulating material extending between first and second opposing edges of said semiconductor wafer and having therein one or more air gaps, the method further comprising forming a second isolation region in said second surface of said semiconductor wafer between said first and second device regions, said second isolation region comprising a trench extending from said second surface to said first isolation region, and providing a high voltage power device in said first device region and a second device in said second device region.

Still further in accordance with the second aspect of the present invention, there is provided an integrated circuit, comprising a semiconductor wafer having first and second device regions, a high voltage power device being provided in said first device region and a second device being provided in said second device region, the integrated circuit further comprising a first isolation region comprising an insulating material separating said first and second device regions of said semiconductor wafer, said insulating material extending between first and second opposing edges of said semiconductor wafer and having therein one or more air gaps, and a second isolation region in said second surface of said semiconductor wafer between said first and second device regions, said second isolation region comprising a trench extending from said second surface to said first isolation region.

Thus, the present invention enables the manufacture of an integrated circuit comprising two or more device regions which are completely dielectrically insulated from each other, wherein the air gaps in the first isolation region serve additionally to reduce mechanical stress in the structure.

In a preferred embodiment, the step of forming the first isolation region comprises forming a plurality of adjacent trenches in the first surface of the semiconductor wafer and performing an oxidation process such that the portions of the semiconductor wafer between the adjacent trenches are oxidised and the trenches are partially filled with oxide material such that the unfilled portions thereof define the air gaps.

In fact, the present invention extends still further to a method of forming an isolation region in a semiconductor wafer, the method comprising forming a plurality of adjacent trenches in a first surface of the semiconductor wafer and performing an oxidation process such that the portions of the semiconductor wafer between the adjacent trenches are oxidised and the trenches are partially filled with oxide material such that the unfilled portions thereof define air gaps in the isolation region.

The width of the trenches can be selected to accommodate the increase in volume resulting from the oxidation process.

The trenches may comprise parallel linear trenches extending between first and second opposing edges of the semiconductor wafer. In a first exemplary embodiment, the trenches may be substantially parallel to the above-mentioned opposing edges of the semiconductor wafer. However, this is not essential. In fact, the trenches may extend at an angle (say, for example, around 45°) to the opposing edges. They may also be non-linear. For example, they may be chevron-shaped (when the semiconductor wafer is viewed from above), which would not only enable the provision of a flexible isolation region (or "membrane") in respect of which stress resulting from a temperature gradient which occurs during operation of the device is reduced, but such non-linear trenches would also have a greater thermal resistance because of their greater length.

It will be appreciated that the method of the present invention can be used to isolate from each other two high voltage power devices integrated on a single semiconductor wafer, a high voltage power device from low voltage (logic) circuitry, or, more generally, hot power areas from cool ip areas on a die.

It will be appreciated that the portion of semiconductor wafer which connects the device regions of the semiconductor wafer together (i.e. the first isolation region) is continuous (i.e. it contains no interface) since it originates from the original crystal, a fact which contributes significantly to the overall strength of the structure. Furthermore, the dimensions of the first isolation region can be chosen such that the cross-sectional are of the region per unit length of isolation is relatively large, a feature which can also be exploited to contribute to the overall strength of the structure.

These and other aspects of the present invention will be apparent from, and elucidated with reference to the embodiments described herein.

Embodiments of the first aspect of the present invention will now be described by way of examples only and with reference to the accompanying drawings, in which:
Figure 1 is a schematic side view of a semiconductor wafer;
Figure 2 is a schematic cross-sectional side view illustrating the deposition/implantation of impurities into the semiconductor wafer of Figure 1;
Figure 3 is a schematic cross-sectional side view of the structure of Figure 2, after performance of a thermal annealing process;
Figure 4 is a schematic cross-sectional view illustrating the structure of an integrated circuit according to an exemplary embodiment of the present invention;
Figure 5 is a schematic side view of a semiconductor wafer;
Figure 6 is a schematic cross-sectional side view of the wafer of Figure 5, wherein a bottom trench has been etched;
Figure 7 is a schematic cross-sectional side view of the structure of Figure 6, wherein two impurity regions have been implanted/deposited;
Figure 8 is a schematic cross-sectional side view illustrating the structure of an integrated circuit according to a second exemplary embodiment of the present invention;
Figure 9 is a schematic side view of a semiconductor wafer;
Figure 10 is a schematic cross-sectional side view of a structure illustrating the formation of a buried layer into the wafer of Figure 9;
Figure 11 is a schematic cross-sectional side view of the structure of Figure 10 following the growth of an epitaxial layer;
Figure 12 is a schematic cross-sectional side view of the structure of Figure 11 following the deposition/implantation of an impurity region in the epitaxial layer;
Figure 13 is a schematic cross-sectional side view of the structure of Figure 12 following a thermal annealing process; and
Figure 14 is a schematic cross-sectional side view illustrating the structure of an integrated circuit according to a third exemplary embodiment of the present invention.
   An embodiment of the second aspect of the present invention will now be described by way of example only and with reference to the accompanying drawings, in which:
Figure 15 is a schematic perspective view of a semiconductor wafer;
Figure 16 is a schematic plan view of the semiconductor wafer of Figure 1, wherein a row of trenches has been formed in the top trench region thereof;
Figure 17 is a schematic plan view of the semiconductor wafer of Figure 2, wherein an oxidation process has been performed in respect of the top trench region;
Figure 18 is a schematic perspective view of the semiconductor wafer of Figure 3;
Figure 19 is a schematic plan view of an integrated circuit according to an exemplary embodiment of the present invention;
Figure 20 is a schematic cross-sectional view of the integrated circuit of Figure 5;
Figure 21 is a schematic perspective view of an integrated circuit according to an exemplary embodiment of the present invention;
Figure 22 is a partial schematic cross-sectional view of an integrated circuit according to a first specific exemplary embodiment of the present invention;
Figure 23 is a schematic cross-sectional view of an integrated circuit according to a second specific exemplary embodiment of the present invention;
Figure 24 is a schematic cross-sectional view of an integrated circuit according to a third specific exemplary embodiment of the present invention; and
Figure 25 is a schematic cross-sectional view of an integrated circuit according to a fourth specific exemplary embodiment of the present invention.

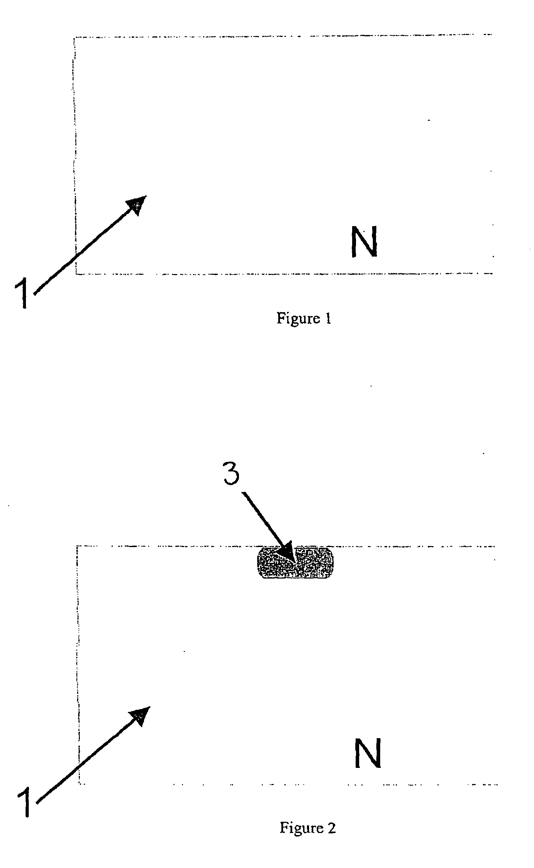

A process according to a first exemplary embodiment of the present invention will now be described with reference to Figures 1 to 4 of the drawings.

Referring to Figure 1 of the drawings, the starting material in the manufacture of an integrated circuit according to an exemplary embodiment of the present invention is a semiconductor, typically silicon, wafer **1.** In this case, the wafer **1** is of n-type silicon, but it will be apparent to a person skilled in the art that the starting material could equally be a p-type semiconductor.

Next, and referring to Figure 2 of the drawings, a region 3 of impurities is provided, by implantation or deposition, into the semiconductor wafer 1. The impurities in the region 3 are of opposite type to the semiconductor wafer 1. Thus, in this case, where the semiconductor wafer is n-type, the impurities in region 3 will be p-type. However, it will be appreciated that, if the semiconductor wafer 1 is p-type, then the impurities in region 3 will be n-type.

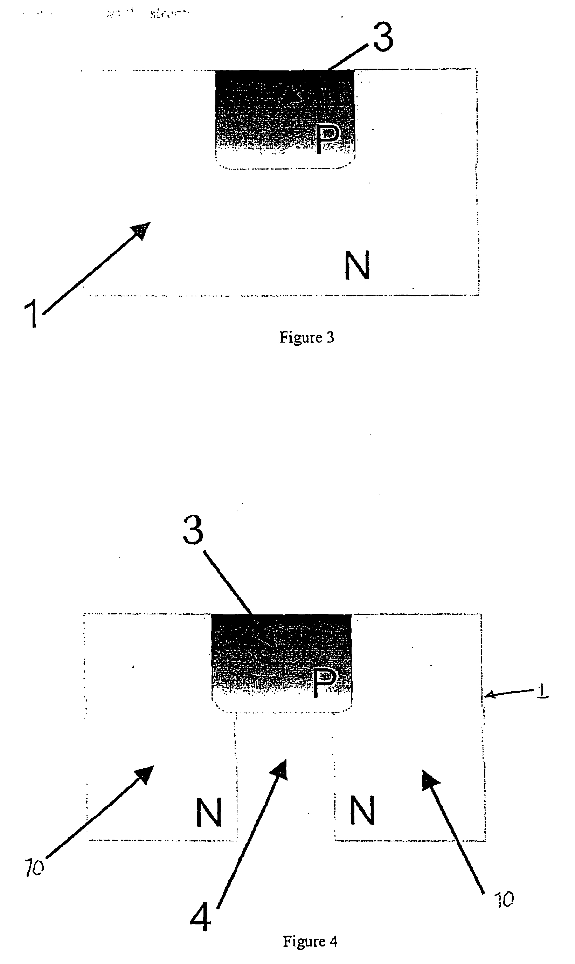

The impurity region 3 is hardened and stabilised by a thermal annealing process, which results in the structure illustrated schematically in Figure 3 of the drawings. It can be seen that the annealing process has resulted in growth of the impurity region 3 within the wafer 1.

Finally, and referring to Figure 4 of the drawings, a trench 4 is created which extends from the rear or bottom surface of the wafer 1 to the impurity region 3, thereby achieving complete isolation between to device regions 10 of the wafer 1. The bottom trench 4 can be created by means of any suitable technique, such as wet chemical etching or plasma ion (Bosh) etching.

The device regions 10 are completely electrically isolated under the proper biasing conditions (i.e. a reverse bias voltage being applied to the p-n junction), and these regions 10 can therefore be used to accommodate high voltage power devices (lateral or vertical) as well as low voltage BiCMOS circuitry. It will be appreciated that this process can be extended to create more than two electrically isolated semiconductor regions.

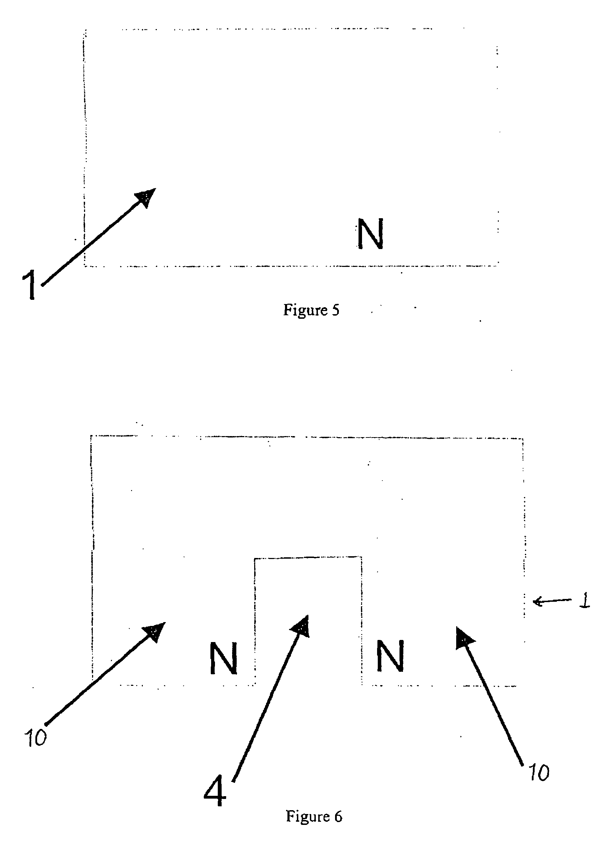

A process according to a second exemplary embodiment of the present invention will now be described with reference to Figures 5 to 8 of the drawings.

Once again, and referring to Figure 5 of the drawings, the starting material for an integrated circuit manufactured according to a second exemplary embodiment of the present invention is a semiconductor, typically silicon, wafer 1. Once again, the illustrated wafer 1 is of n-type, but it could equally be of p-type, as required by the application.

Referring to Figure 6 of the drawings, a trench 4 is created in the rear or bottom surface of the semiconductor wafer 1, such that two device regions 10 can now be distinguished. Once again, the trench 4 may be created using any suitable technique, for example, wet chemical etching or plasma ion (Bosh) etching.

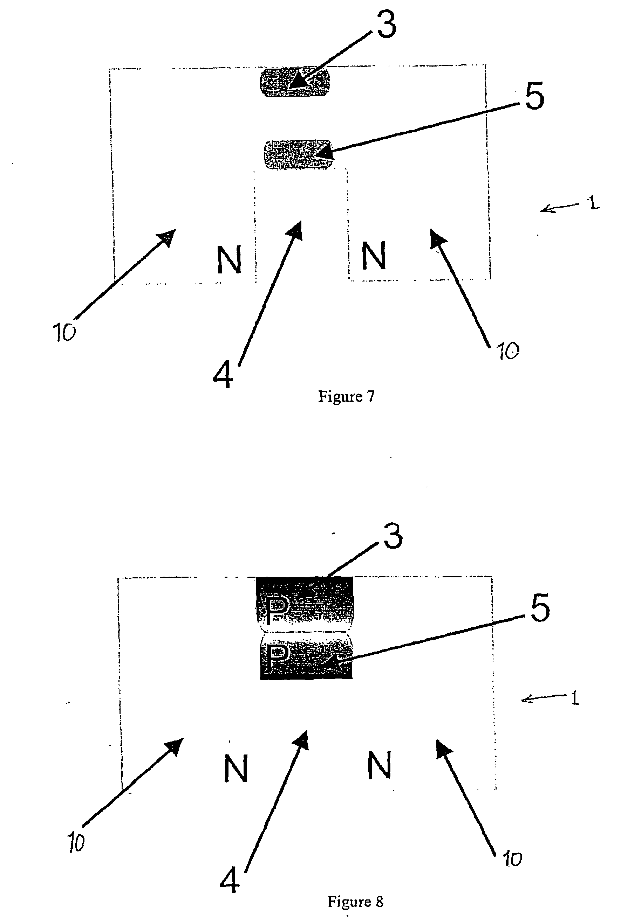

Referring to Figure 7 of the drawings, two impurity regions are deposited or implanted into the semiconductor wafer, the first impurity region 3 being implanted/deposited adjacent the front or top surface of the wafer 1, and the second impurity region 5 being located adjacent the trough of the trench 4, as shown. The impurity regions 3, 5 are both of opposite type to the semiconductor wafer 1. Thus, in this case, the semiconductor wafer 1 is of n-type, so the impurity regions 3, 5 are of p-type. However, if the wafer is of p-type, then the impurity regions will be of n-type so as to create the requisite p-n junction for the junction isolation part of the structure.

Finally, a thermal annealing process is performed, which results in growth of the impurity regions 3, 5 within the semiconductor wafer 1. As illustrated in Figure 8 of the drawings, the thermal annealing step results in the growth of the impurity regions 3, 5 within the wafer such that they effectively fill the portion of the wafer left between the two device regions 10. As a result, the device regions 10 are completely electrically isolated under the proper biasing conditions (i.e. a reverse bias voltage being applied to the p-n junction), and these regions 10 can therefore be used to accommodate high voltage power devices (lateral or vertical) as well as low voltage BiCMOS circuitry. It will be appreciated that this process can be extended to create more than two electrically isolated semiconductor regions.

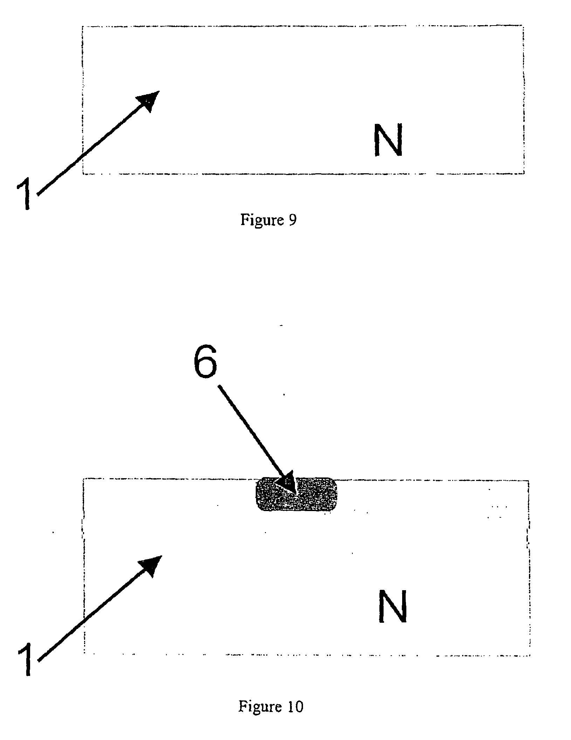

A process according to a third exemplary embodiment of the present invention will now be described with reference to Figures 9 to 14 of the drawings.

Referring to Figure 9 of the drawings, the starting material in the following process is, once again, a semiconductor (typically silicon) wafer 1, in this case, once again, of n-type.

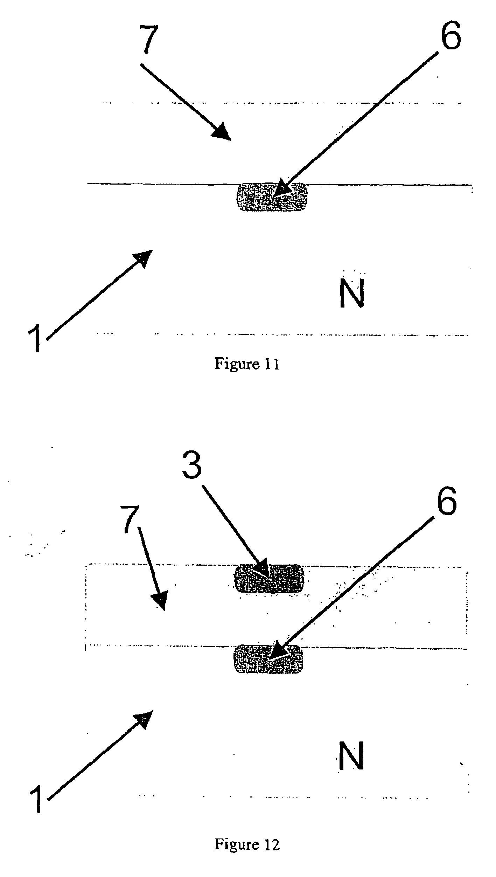

Referring to Figure 10 of the drawings, a first buried layer 6 of a type opposite to that of the semiconductor wafer 1 (in this case, p-type) is formed within the initial semiconductor material. Next, epitaxial growth of a drift layer 7 is performed, as illustrated schematically in Figure 11 of the drawings, and an impurity region 3 is deposited/implanted into the epitaxial layer 7. The impurity region 3 is of a type opposite to that of the epitaxial layer 7. In this case, the epitaxial layer 7 is of the same type as the semiconductor wafer 1, i.e. n-type, and the impurity region 3 is therefore of p-type.

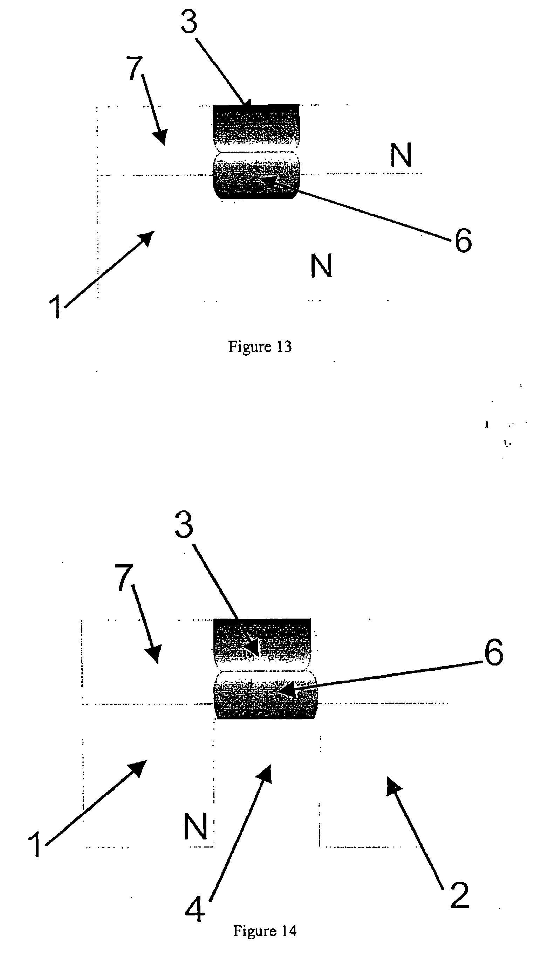

A thermal annealing process is performed in respect of the structure of Figure 12, which results in growth of the buried layer 6 and the impurity region 3 within the wafer 1, as shown schematically in Figure 13 of the drawings, to the extent that the two regions 3, 6 are joined together to define two distinct regions of the epitaxial layer 7 on either side thereof.

Finally, a trench 4 is created, which extends from the rear or bottom surface of the semiconductor wafer 1 to the bottom of the buried layer 6, to define two distinct device regions of the semiconductor wafer 1. The trench may be created by any suitable method, for example, wet chemical etching or plasma ion (Bosh) etching.

As a result, the device regions 10 are completely electrically isolated under the proper biasing conditions (i.e. a reverse bias voltage being applied to the p-n junction), and these regions 10 can therefore be used to accommodate high voltage power devices (lateral or vertical) as well as low voltage BiCMOS circuitry. It will be appreciated that this process can be extended to create more than two electrically isolated semiconductor regions.

Thus, the processes and structures described above in accordance with exemplary embodiments of the first aspect of the present invention provide a means for vertical isolation in power integrated circuits which combines dielectric and junction isolation, and as a result of which two or more areas of a semiconductor wafer/chip are completely electrically isolated from each other under the correct biasing conditions.

Embodiments of the first aspect of the present invention have been described above by way of examples only, and it will be apparent to a person skilled in the art that modifications and variations can be made to the described embodiments without departing from the scope of the invention as defined by the appended claims.

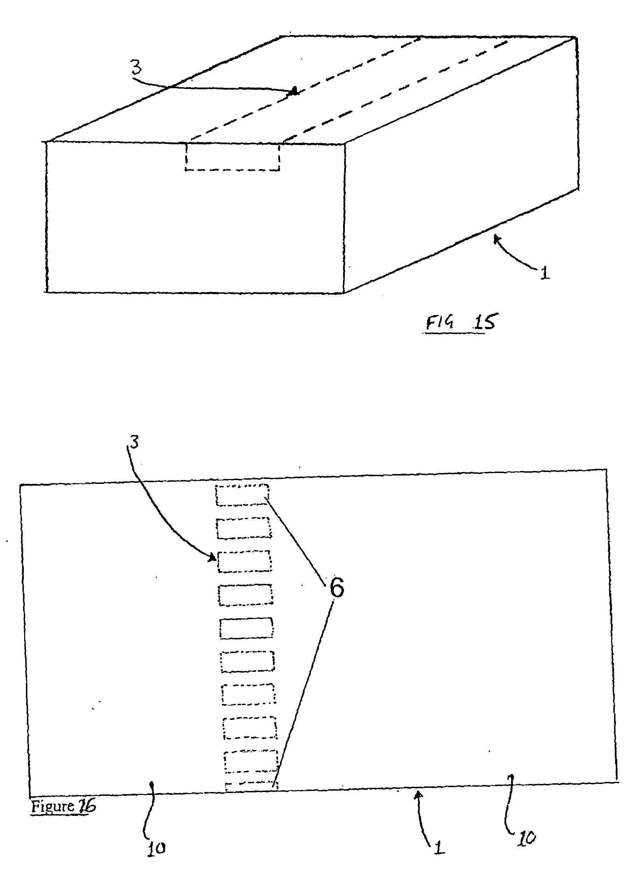

Referring to Figure 15 of the drawings, the starting material for an integrated circuit according to an exemplary embodiment of the present invention is a semiconductor, typically silicon, wafer 1. In the final circuit, dielectric isolation between two or more power device regions (or power device regions and analogue/digital circuit regions) is achieved using top and bottom trench combinations, as will now be described in more detail.

A top trench region 3 is defined in the front or upper surface of the wafer 1, as shown in Figure 15 of the drawings. Referring to Figure 16 of the drawings, a sequence of short, parallel trenches 6 are formed within the region 3 using any suitable etching technique, such as plasma ion (Bosh) etching. As shown, the region 3 now defines two power device semiconductor regions 10, although at this stage in the manufacturing process, there are still uninterrupted semiconductor paths between the two regions 10.

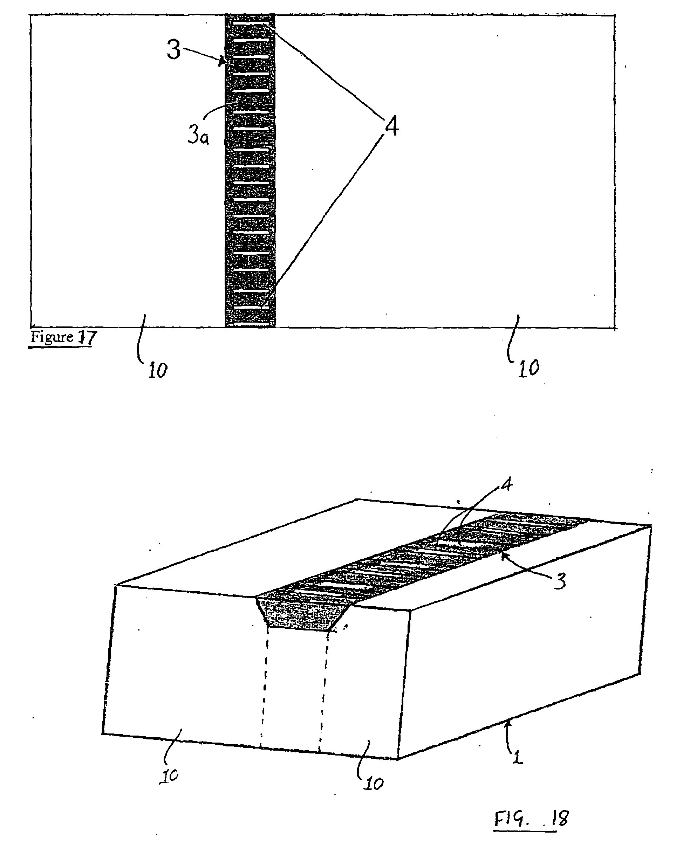

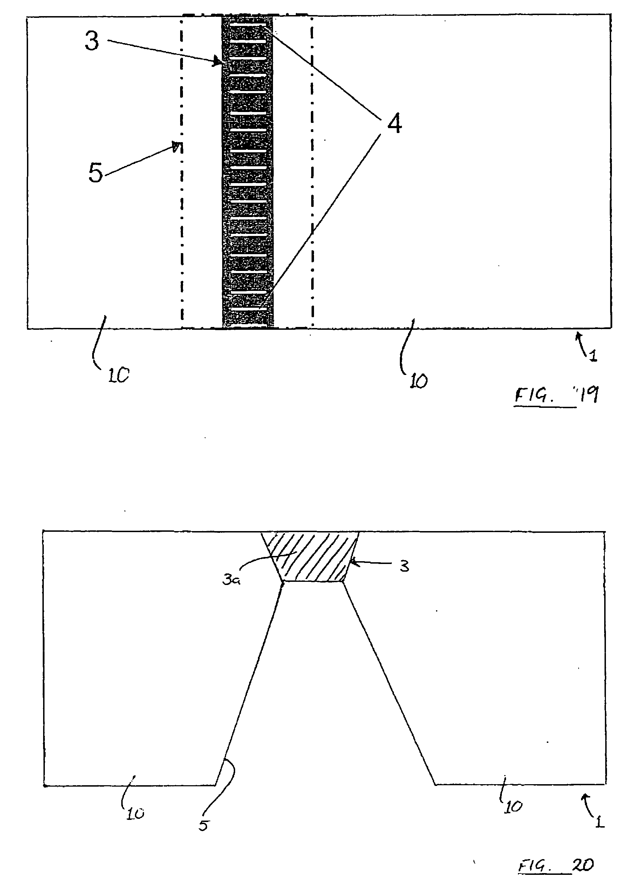

Next, and referring to Figure 17 of the drawings, an oxidation process is performed. During this process, oxide 3a consumes the semiconductor material between the trenches (6, Figure 16) as well as growing within the trenches. Once the oxidation process is complete, the power device regions 10 are completely separated at the front or upper surface of the semiconductor wafer 1, as shown in Figure 18 of the drawings.

The dimensions, positions and number of the trenches (6, Figure 16) are very precisely determined and optimised such that small portions of the region 3 will remain purposely unfilled in order to create air gaps 4 in the final structure which have the effect of reducing mechanical stress in the structure.

Finally, and referring to Figures 19 and 20 of the drawings, complete dielectric isolation between the power device semiconductor regions 10 is achieved by creating a trench 5 in the rear or bottom surface of the wafer 1. This bottom trench 5 may be formed by means of any suitable method, including wet chemical etching or plasma ion (Bosh) etching.

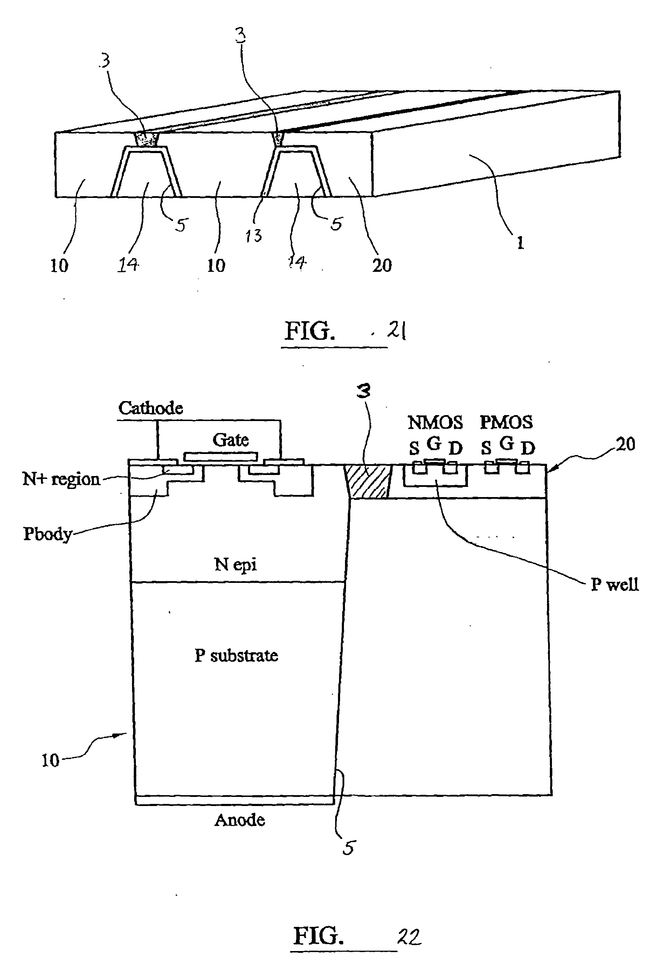

Referring to Figure 21 of the drawings, an integrated circuit according to an exemplary embodiment of the present invention may comprise a semiconductor wafer 1 in which two sets of upper 3 and lower 5 trench regions are etched (preferably simultaneously) in the upper and lower surfaces respectively of the wafer 1, such that two power device regions 10 and a low voltage region 20 can be integrated into the device. This process can, of course, be extended to three or more vertical power devices, as required. The bottom trenches may be covered with an insulating material 13, such as silicon oxide or the like, and/or filled with another material 14, such as another insulating material, glass or metal. In any event, it will be appreciated that the device regions 10 are completely isolated from each other, as well as the low voltage circuitry provided in the low voltage region 20.

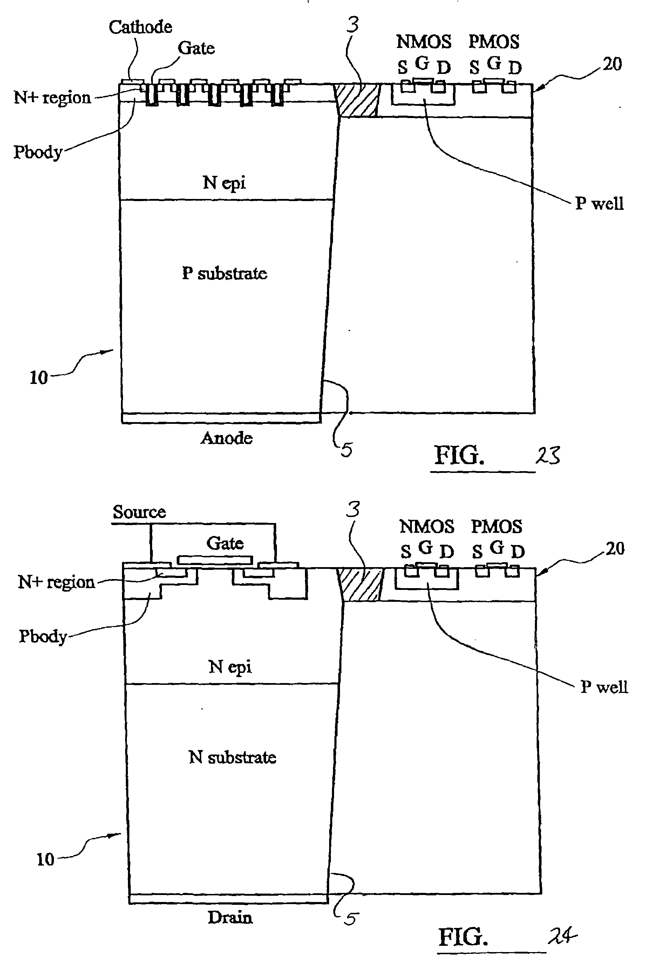

Figure 22 of the drawings illustrates an integrated circuit according to a first specific exemplary embodiment of the present invention, in which a vertical IGBT 10 is integrated with low voltage CMOS circuitry 20.

Figure 23 of the drawings illustrates an integrated circuit according to a second specific embodiment of the present invention, in which a vertical trench IGBT 10 is integrated with low voltage CMOS circuitry 20.

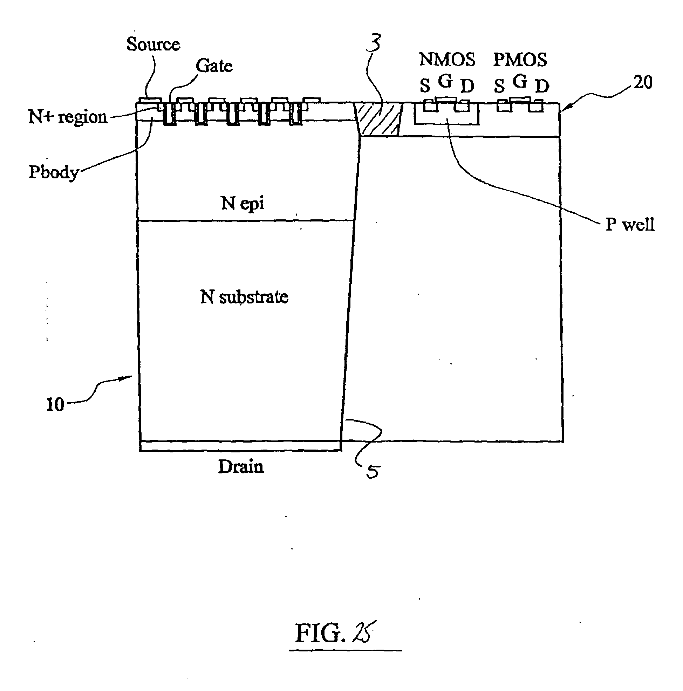

Figure 24 of the drawings illustrates an integrated circuit according to a third specific exemplary embodiment of the present invention, in which a VDMOSFET 10 is integrated with low voltage CMOS circuitry 20.

Figure 25 illustrates an integrated circuit according to a fourth specific exemplary embodiment of the present invention, in which a vertical trench MOSFET 10 is integrated with low voltage CMOS circuitry 20.

Embodiments of the second aspect of the present invention have been described above by way of examples only, and it will be apparent to a person skilled in the art that modifications and variations can be made to the described embodiments, without departing from the scope of the invention as defined by the appended claims.

## Claims

1. A method of electrically isolating from each other two device regions of a semiconductor substrate for use in an integrated circuit, the method comprising providing an impurity region within said semiconductor substrate for providing a diode junction between said two device regions, and creating a trench between said two device regions, said trench extending from a surface of said semiconductor substrate to said impurity region.

2. A method according to claim 1, wherein the impurity region is first implanted or deposited within the semiconductor substrate, following which the trench is created which extends from a surface of the semiconductor substrate to the impurity region, and/or wherein said impurity region is subjected to an annealing process prior to creation of the trench.

3. A method according to claim 1, wherein a trench is first formed in a surface of the semiconductor substrate which defines two device regions on either side thereof, following which at least one impurity region is formed within the semiconductor substrate, and/or wherein a first impurity region is formed adjacent the trough of the trench and a second impurity region is formed adjacent the surface of the semiconductor substrate opposing the surface in which the trench is formed.

4. A method according to claim 3, wherein an annealing process is performed to cause the impurity regions to grow and, as a result, join together to substantially fill a portion of the semiconductor substrate between the two device regions defined by the trench.

5. A method according to claim 1, wherein said impurity region comprises a buried layer of said second type which is formed adjacent a first surface of the semiconductor substrate, following which an epitaxial layer, preferably of the first type, is formed on said first surface of the semiconductor substrate, and/or wherein an impurity region of said second type is formed within the epitaxial layer, and/or wherein an annealing process is performed so as to cause the buried layer and the impurity region to grow and join together to form a diode junction between two device regions of the substrate.

6. A method according to claim 5, wherein a trench is formed which extends from the surface of the substrate opposing said first surface to the buried layer.

7. A method according to any one of claims 1 to 6, wherein the semiconductor substrate is a silicon substrate.

8. A method of electrically isolating from each other two device regions of a semiconductor substrate for use in an integrated circuit, the method being substantially as herein described with reference to the accompanying drawings.

9. A method of manufacturing an integrated circuit comprising a first, high voltage power device, and a second device, the method comprising providing a semiconductor substrate of a first type, forming an impurity region of a second type in said semiconductor substrate for defining a diode junction between two device regions thereof, creating a trench between said two device regions, said trench extending from a surface of said semiconductor substrate to said impurity region, and forming a high voltage power device in one of said device regions and a second device in the other of said device regions.

10. An integrated circuit comprising a first, high voltage, power device and a second device integrated on a common semiconductor substrate of a first type, the integrated circuit further comprising an impurity region of a second type in said semiconductor substrate for defining a diode junction between said first and second devices, and a trench extending from a surface of said semiconductor substrate to said impurity region.

11. An integrated circuit comprising a semiconductor substrate having two devices formed therein, said two devices being electrically isolated from each other by a method according to any one of claims 1 to 8.

12. A method of fabricating an integrated circuit, the method comprising providing a semiconductor wafer having first and second opposing surfaces, forming a first isolation region in said first surface of said semiconductor wafer, said first isolation region comprising an insulating material separating first and second device regions of said semiconductor wafer, said insulating material extending between first and second opposing edges of said semiconductor wafer and having therein one or more air gaps, the method further comprising forming a second isolation region in said second surface of said semiconductor wafer between said first and second device regions, said second isolation region comprising a trench extending from said second surface to said first isolation region, and providing a high voltage power device in said first device region and a second device in said second device region.

13. A method according to claim 12, wherein said second device comprises a high voltage power device, or wherein said second device comprises low voltage control circuitry.

14. A method according to any one of claims 12 to 13, wherein the step of forming the first isolation region comprises forming a plurality of adjacent trenches in the first surface of the semiconductor wafer and performing an oxidation process such that the portions of the semiconductor wafer between the adjacent trenches are oxidised and the trenches are partially filled with oxide material such that the unfilled portions thereof define the air gaps.

15. A method according to claim 14, wherein said trenches comprise parallel trenches extending between first and second opposing edges of the semiconductor wafer.

16. An integrated circuit, comprising a semiconductor wafer having first and second device regions, a high voltage power device being provided in said first device region and a second device being provided in said second device region, the integrated circuit further comprising a first isolation region comprising an insulating material separating said first and second device regions of said semiconductor wafer, said insulating material extending between first and second opposing edges of said semiconductor wafer and having therein one or more air gaps, and a second isolation region in said second surface of said semiconductor wafer between said first and second device regions, said second isolation region comprising a trench extending from said second surface to said first isolation region.

17. A method of isolating a high voltage power device from a second device, said high voltage power device and said second device being provided on a semiconductor wafer comprising first and second opposing surfaces, the method comprising forming a first isolation region in said first surface of said semiconductor wafer, said first isolation region comprising an insulating material separating said high voltage power device and said second device, said insulating material extending between first and second opposing edges of said semiconductor wafer and having therein one or more air gaps, the method further comprising forming a second isolation region in said second surface of said semiconductor wafer between said high voltage power device and said second device, said second isolation region comprising a trench extending from said second surface to said first isolation region.

18. A method of forming an isolation region in a semiconductor wafer, the method comprising forming a plurality of adjacent trenches in a first surface of the semiconductor wafer and performing an oxidation process such that the portions of the semiconductor wafer between the adjacent trenches are oxidised and the trenches are partially filled with oxide material such that the unfilled portions thereof define air gaps in the isolation region.
